(19) Europäisches Patentamt
European Patent Office
Office européen des brevets

(11) **EP 2 120 342 A1**

(12) **EUROPEAN PATENT APPLICATION**

(43) Date of publication:
**18.11.2009 Bulletin 2009/47**

(51) Int Cl.:
***H03L 7/087*** *(2006.01)*

(21) Application number: **09160318.3**

(22) Date of filing: **14.05.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **15.05.2008 IT TO20080368**

(71) Applicant: **SELEX COMMUNICATIONS S.p.A.**
**16151 Genova (IT)**

(72) Inventors:
 • **Vergari, Fabrizio**
 **00143 Roma (IT)**
 • **Rossetti, Pierluigi**
 **00175 Roma (IT)**

(74) Representative: **Jorio, Paolo et al**
**STUDIO TORTA**
**Via Viotti 9**
**10121 Torino (IT)**

(54) **Digital phase-locked loop**

(57)     Described herein is a digital phase-locked loop (10) designed to receive an input signal ($s_i(t)$), having an oscillator (40) and a phase detector (20). The oscillator (40) generates a first harmonic signal and a second harmonic signal having the same reference phase ($\phi_{VCO}(t)$), but for a phase offset of 90 degrees. The phase detector (20) calculates a quantity linearly proportional to the difference between the phase ($\phi_i(t)$) of the input signal ($s_i(t)$) and the reference phase ($\phi_{VCO}(t)$) by means of extraction of an in-phase component ($s_{ii}(t)$) and a quadrature component ($s_{iq}(t)$) of the input signal ($s_i(t)$) with respect to the reference phase ($\phi_{VCO}(t)$).

Fig.4

EP 2 120 342 A1

**Description**

The present invention relates to a digital phase-locked loop.

As is known, a phase-locked loop (PLL) is an electronic control system configured for receiving an input signal $s_i(t)$, typically a sinusoidal signal with pulsation $\omega_i(t)$ and with instantaneous phase $\phi_{i0}(t)$, and generate a sinusoidal reference signal $s_{VCO}(t)$ with pulsation $\omega_{VCO}(t)$, the instantaneous phase $\phi_{VCO\_0}(t)$ of which respects a given relation with the instantaneous phase $\phi_{i0}(t)$ of the input signal $s_i(t)$.

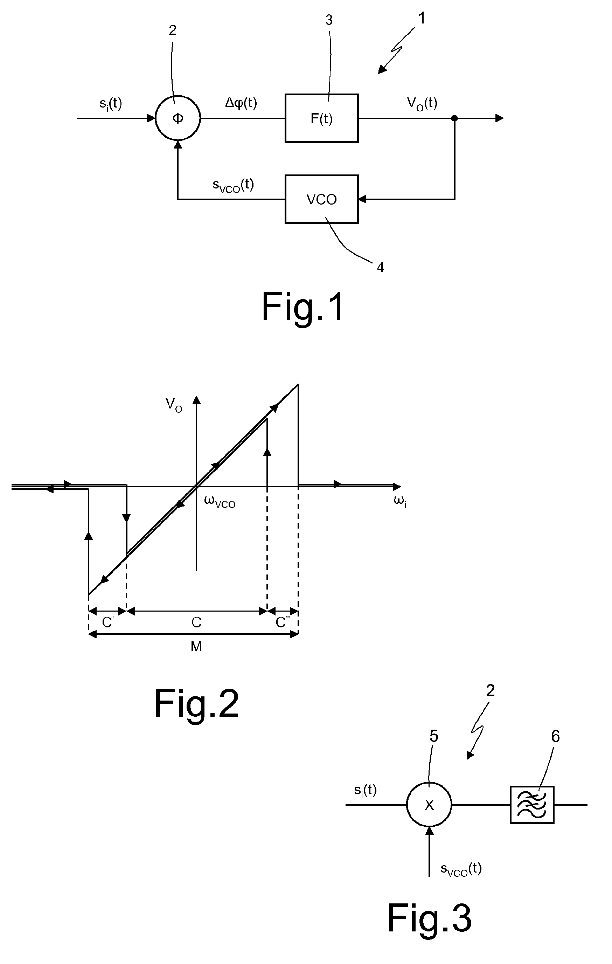

As illustrated in Figure 1, a phase-locked loop, designated as a whole by 1, comprises:

- a phase detector 2, receiving the input signal $s_i(t)$ and the reference signal $s_{VCO}(t)$, and configured for supplying an error signal $\Delta\phi(t)$ indicating the phase difference between the input signal $s_i(t)$ and the reference signal $s_{VCO}(t)$, as described in detail in what follows;
- a loop filter 3, possibly with gain higher than 1, receiving the aforementioned error signal $\Delta\phi(t)$ and supplying a control signal $V_o(t)$; and
- a voltage-controlled oscillator (VCO) 4, i.e., a device generating a sinusoidal signal the pulsation of which depends upon the voltage present at input to the voltage-controlled oscillator itself; the voltage-controlled oscillator 4 receives the control signal $V_o(t)$ and generates the aforementioned reference signal $s_{vco}(t)$, the pulsation of which $\omega_{VCO}(t)$ is hence proportional to the control signal $V_o(t)$.

The phase detector 2, the loop filter 3, and the voltage-controlled oscillator 4 are set so as to form a feedback loop, which acts so that the instantaneous phase $\phi_{VCO\_0}(t)$ and, consequently, the pulsation $\omega_{VCO}(t)$ of the reference signal $s_{VCO}(t)$ approximate, respectively, the instantaneous phase $\phi_{i0}(t)$ and the pulsation $\omega_i(t)$ of the input signal $s_i(t)$.

From a mathematical standpoint, assuming that the input signal $s_i(t)$ and the reference signal $s_{VCO}(t)$ have corresponding amplitudes $A_i$ and $A_{VCO}$, they can be written, respectively, according to Eq. (1) and Eq. (2):

$$ s_i(t) = A_i \cdot \cos[\varphi_i(t)] = A_i \cdot \cos[\omega_i \cdot t + \varphi_{i0}(t)] = A_i \cdot \cos[\omega_i \cdot t + \phi_i(t) + \phi] \qquad (1) $$

$$ s_{VCO}(t) = A_{VCO} \cdot \cos[\varphi_{VCO}(t)] = A_{VCO} \cdot \cos[\omega_{VCO}(t) \cdot t + \varphi_{VCO\_0}(t)] = $$
$$ = A_{VCO} \cdot \cos\{[\omega_{VCO} + \Delta\omega_{VCO}(t)] \cdot t + \varphi_{VCO\_0}(t)\} \qquad (2) $$

From Eq. (1) it emerges that the instantaneous phase $\phi_{i0}(t)$ of the input signal $s_i(t)$ comprises a possible constant component $\phi$ and an instantaneous phase deviation $\phi_i(t)$, i.e., an instantaneous deviation with respect to the term $\omega_i \cdot t$ intrinsic to a monochromatic signal at a frequency $F_0(t)$ (with $\omega_i(t) = 2\pi F_0(t)$), as is, precisely, the input signal $s_i(t)$. The phase $\phi_i(t)$ of the input signal $s_i(t)$ itself is hence given by the sum of the term $\omega_i \cdot t$ and the instantaneous phase $\phi_{i0}(t)$.

Likewise, Eq. (2) highlights that the pulsation $\omega_{VCO}(t)$ of the reference signal $s_{VCO}(t)$, the phase of which is designated as $\phi_{VCO}(t)$, comprises a fixed-pulsation component $\omega_{VCO}$ (rest pulsation), characteristic of the voltage-controlled oscillator 4, and a variable-pulsation component $\Delta\omega_{VCO}(t)$, depending upon the control signal $V_o(t)$ set at input to the voltage-controlled oscillator 4. Typically, the variable-pulsation component $A\omega_{VCO}(t)$ is proportional to the control signal $V_o(t)$ through a coefficient of proportionality $K_{VCO}$, which is also characteristic of the voltage-controlled oscillator 4. Operatively, in the presence of zero voltage on their own input, voltage-controlled oscillators of the type commonly available on the market generate a harmonic reference signal $s_{VCO}(t)$ having a pulsation equal to the rest pulsation $\omega_{VCO}$.

Thanks to the feedback loop, in the phase-locked condition, i.e., once an initial transient has ceased, the instantaneous phase $\phi_{VCO\_0}(t)$ of the reference signal $s_{VCO}(t)$ follows the instantaneous phase $\phi_{i0}(t)$ of the input signal $s_i(t)$, i.e., it follows the time evolution thereof, possibly but for a residual phase error. Clearly, the aforementioned phase-locked condition presupposes that the pulsation $\omega_{VCO}(t)$ of the reference signal $s_{VCO}(t)$ is equal to the pulsation $\omega_i(t)$ of the input signal $s_i(t)$; otherwise, there would be generation of a phase error linearly increasing in time.

From a more quantitative standpoint, the capacity of the phase-locked loop 1 to follow the pulsation $\omega_i(t)$ of the input signal $s_i(t)$ finds an effective graphic representation in the so-called butterfly characteristic of the phase-locked loop 1, an illustrative example of which is represented in Figure 2.

In detail, Figure 2 shows the presence of:

- a capture band C, i.e., a range of frequencies admissible for the pulsations $\omega_i(t)$ of the input signal $s_i(t)$, centred around the rest pulsation $\omega_{VCO}$ of the voltage-controlled oscillator 4; when the input signal $s_i(t)$ has pulsation $\omega_i(t)$ comprised within the capture band C, the phase-locked loop 1 manages to lock the input signal $s_i(t)$ itself;

- a hold band M, i.e., a range of frequencies admissible for the pulsations $\omega_i(t)$ of the input signal $s_i(t)$, which is also centred around the rest pulsation $\omega_{VCO}$ of the voltage-controlled oscillator 4 and spectrally more extensive than the aforementioned capture band C, so as to define two side sub-bands C' and C" set at the sides of the capture band C; when the input signal $s_i(t)$ has a pulsation $\omega_i(t)$ comprised within the sub-bands C' and C", the phase-locked loop 1 manages to hold locking of the input signal $s_i(t)$, but not to establish the phase locking, if not already present.

The capacity of the phase-locked loop 1 for following variations of the instantaneous phase $\phi_{i0}(t)$ and of the pulsation $\omega_i(t)$ (phase steps, phase ramps, phase parabolas, etc.) of the input signal $s_i(t)$, and hence the spectral amplitudes of the aforementioned capture band C and hold band M, substantially depend upon the transfer function of the loop filter 3, as well as upon the coefficient of proportionality $K_{VCO}$ of the voltage-controlled oscillator 4.

The transfer function of the loop filter 3 also concurs, once again together with the coefficient of proportionality $K_{VCO}$ of the voltage-controlled oscillator 4, to the determination of the transfer function and of the stability of the phase-locked loop 1 as a whole, which can be studied with the techniques regarding feedback systems, said techniques being known and consequently not being described herein.

Precisely on account of the capacity for frequency and phase locking of signals coming from the outside world, phase-locked loops are commonly used in the fields of telecommunications, radio-frequency receivers, computers, and electronic devices in general. In greater detail, use thereof is known as stable frequency generators, means for recovery of carriers of RF modulated signals, or else in networks for the distribution of the clock in logic circuits, for example in microprocessors.

There is moreover known the use of phase-locked loops within devices for demodulating frequency-modulated signals. In the case of an input signal $s_i(t)$ modulated in frequency with a modulating signal X(t), the instantaneous phase deviation $\phi_i(t)$ is given by Eq. (3):

$$\phi_i(t) = \int \overline{X(t)} dt \qquad\qquad (3)$$

In principle, the modulating signal X(t) can be recovered by extracting the control signal $V_o(t)$, which becomes the output signal of the phase-locked loop. This output signal is proportional to the variations in frequency of the input signal $s_i(t)$, and hence to the modulating signal X(t).

Even though they are suited for the aforementioned uses and can be described exhaustively by means of mathematical equations that model the behaviour of the components (phase detector, loop filter, and voltage-controlled oscillator), phase-locked loops present certain critical aspects. In fact, the overall performance of phase-locked loops departs from what is defined in the design stage on account of the non-idealities inherent in the implementations, which are typically analog, of the subcomponents. In particular, the implementation of the phase detector represents a critical aspect for the purposes of determination of the overall performance of the phase-locked loop.

As schematically illustrated in Figure 3, in phase-locked loops of a known type, the phase detection, i.e., the determination of the difference between the phase $\phi_i(t)$ of the input signal $s_i(t)$ and the phase $\phi_{VCO}(t)$ of the reference signal $s_{VCO}(t)$, is generally made in an approximate way by using a multiplier 5 followed by a lowpass filter 6. In phase-locked conditions, i.e., in the operative conditions for which a phase-locked loop is designed, the multiplication of the input signal $s_i(t)$ by the reference signal $s_{VCO}(t)$ generates a product signal, comprising a d.c. component and a sinusoidal component with a frequency that is twice the frequency of the input signal $s_i(t)$. The lowpass filter 6 is designed so as to filter the aforesaid sinusoidal component and allow the d.c. component to pass. In the aforementioned phase-locked conditions, the d.c. component is proportional to the sine of the difference between the instantaneous phase $\phi_{i0}(t)$ of the input signal $s_i(t)$ and the instantaneous phase $\phi_{VCO\_0}(t)$ of the reference signal $s_{VCO}(t)$, i.e., to the sine of the difference between the phase $\phi_i(t)$ of the input signal $s_i(t)$ and the phase $\phi_{VCO}(t)$ of the reference signal $s_{VCO}(t)$, since the pulsation $\omega_i(t)$ of the input signal $s_i(t)$ and the pulsation $\omega_{VCO}(t)$ of the reference signal $s_{VCO}(t)$ coincide.

Consequently, for small phase differences, the d.c. component can be considered a good approximation of the difference between the phases of the input signal $s_i(t)$ and of the reference signal $s_{VCO}(t)$.

As the phase difference increases between the input signal $s_i(t)$ and the reference signal $s_{VCO}(t)$, the output of the phase detector 2 approximates progressively less the phase difference itself, generating non-linear effects that limit the overall performance of the phase-locked loop 1.

The non-linearity is particularly harmful in the case where the phase-locked loop 1 is used with function of demodulator of frequency-modulated signals. In fact, the non-linearity prevents a correct extraction of the modulating signal X(t).

Furthermore, when implemented in analog form, the phase detector 2 of the type described is affected by the problems inherent in analog applications in general, such as the dependence upon the constructional tolerances of the components (multiplier 5 and lowpass filter 6) with respect to the corresponding design values, the sensitivity in regard to variations in temperature and the need to render the VCO immune to variations in its supply voltage (e.g.,. common-mode signals).

The aim of the present invention is to provide a digital phase-locked loop that solves at least in part the drawbacks of the known art.

According to the present invention, a digital phase-locked loop and a digital-processing system are provided, as defined in Claims 1 and 9, respectively.

For a better understanding of the invention, an embodiment thereof is now described purely by way of non-limiting example and with reference to the attached drawings, wherein:

- Figure 1 shows a block diagram of an ideal phase-locked loop;
- Figure 2 shows a butterfly characteristic illustrating the locking capacity of a phase-locked loop;
- Figure 3 shows a block diagram of a phase detector according to the known art;
- Figure 4 shows a block diagram of a digital phase-locked loop according to one embodiment of the present invention;
- Figures 5 and 6 show, respectively, the plot of the magnitude and phase of a transfer function of a digital phase-locked loop according to the embodiment of Figure 4;
- Figure 7 shows the plot of the signal-to-noise ratio at output from a digital phase-locked loop according to the embodiment of Figure 4, in relation to the signal-to-noise ratio present at input;
- Figure 8 shows a flowchart illustrating an algorithm for calculation of an arctangent function;
- Figure 9 illustrates a digital-processing system comprising the digital phase-locked loop according to the embodiment of Figure 4; and
- Figure 10 shows a design mask corresponding to a FIR filter forming part of a digital phase-locked loop according to the embodiment Figure 4.

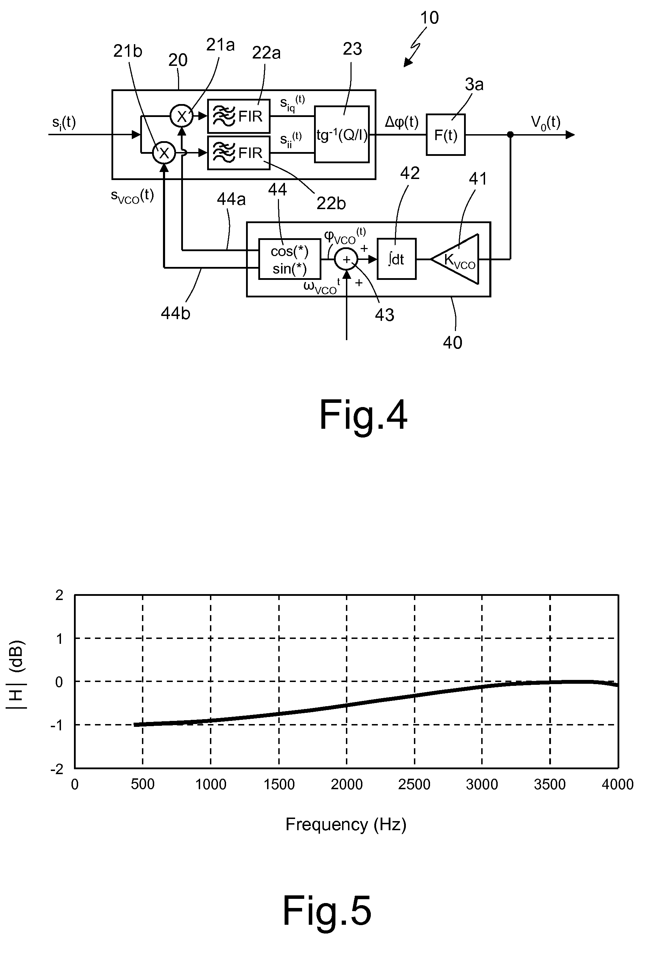

Figure 4 shows a digital phase-locked loop 10 designed to receive an input signal $s_i(t)$, and comprising:

- a quadrature voltage-controlled oscillator (QVCO) 40 having one input and two outputs, and comprising in turn: a amplifier block 41, with gain coinciding with the coefficient of proportionality $K_{VCO}$ of the QVCO 40; an integrator 42, set in series to the amplifier block 41; an adder 43, set in series to the integrator 42 and designed to add the signal generated by the integrator 42 to a component corresponding to the rest pulsation $\omega_{VCO}$ of the QVCO 40, which is equal to the product between the rest pulsation $\omega_{VCO}$ itself and the time $t$ elapsing from the start of operation of the digital phase-locked loop 10; and a reference generator block 44, which is connected in series to the adder 43, has an in-phase output 44a and a quadrature output 44b, which coincide with the outputs of the QVCO 40, and is designed to generate on said two outputs, respectively, two tones (harmonic signals) in quadrature, i.e., a cosine function and a sine function having as argument the output signal from the adder 43, which in what follows is referred to as reference phase $\phi_{VCO}(t)$;
- a phase detector 20, having three inputs and one output, the first input being configured for receiving the input signal $s_i(t)$, the second and third inputs being instead configured for being connected, respectively, to the in-phase output 44a and to the quadrature output 44b of the QVCO 40; the phase detector 20 in turn comprises: two multipliers 21a and 21b, each connected in series to corresponding FIR filters 22a and 22b, and having at input the input signal $s_i(t)$ and, respectively, the cosine function and the sine function at output from the QVCO 40, so as to generate, at the output of the corresponding FIR filters 22a and 22b, a component in quadrature $s_{iq}(t)$ and a component in phase $s_{ii}(t)$ of the input signal $s_i(t)$ with respect to the reference phase $\phi_{VCO}(t)$; a calculation block 23, receiving the afore-mentioned in-phase component $s_{ii}(t)$ and quadrature component $s_{iq}(t)$ of the input signal $s_i(t)$ and designed to calculate the arctangent of the ratio between the amplitudes, respectively, of the quadrature component $s_{iq}(t)$ and the in-phase component $s_{ii}(t)$, so as to supply a signal linearly proportional to the phase difference between the input signal $s_i(t)$ and the reference phase $\phi_{VCO}(t)$; and
- a unitary loop filter 3a, i.e., a filter that transfers onto its own output the same signal present on its own input.

In greater detail, the digital phase-locked loop 10 receives at input samples of the input signal $s_i(t)$, sampled with a sampling frequency $F_c$; consequently, the digital phase-locked loop 10 operates in the discrete-time domain. However, for reasons of simplicity, in the sequel of the present description use is made of continuous-time expressions, since they are equivalent to corresponding discrete-time expressions, where the time variable is replaced by multiples of the sampling period $T_c$.

As compared to phase-locked loops of a known type, the digital phase-locked loop 10 does not have a single reference signal $s_{vco}(t)$ on the feedback branch, but rather two quadrature tones, i.e., two sinusoidal signals having, but for a fixed phase offset of 90 degrees, the same phase, equal to the aforementioned reference phase $\phi_{VCO}(t)$, equal to

$$\omega_{VCO}t + K_{VCO}\int V_o(t)dt \ .$$

Given the phase detector 20 described, it is possible to show that it has a transfer function $\Delta\Phi(\omega)$ equal to

$$\Delta\Phi(\omega) = (\Phi_i - \Phi_{VCO}) \cdot e^{-j\omega\tau_G} \qquad (4)$$

where $\Phi_i$ and $\Phi_{VCO}$ represent the Laplace transforms of the phase $\phi_i(t)$ of the input signal $s_i(t)$ and of the reference phase $\phi_{VCO}(t)$, whilst $\tau_G$ is the group delay introduced by the FIR filters 22a and 22b of the phase detector 20. In the case of FIR filters 22a and 22b with N coefficients, the delay $\tau_G$ is equal to N/(2F$_c$).

As brought out by Eq. (4), the phase detector 20 described has a quasi-ideal behaviour since it supplies the difference between the phase $\phi_i(t)$ of the input signal $s_i(t)$ and the reference phase $\phi_{VCO}(t)$, introducing only a delay due to the presence of the FIR filters 22a and 22b.

As regards the overall performance of the digital phase-locked loop 10 described, said performance may be appreciated, without this implying any loss of generality, with reference to use of the digital phase-locked loop as demodulator of a frequency-modulated input signal $s_i(t)$. In particular, assuming a sinusoidal input signal $s_i(t)$ with fixed pulsation $\omega_o$ ($\omega_i(t) = \omega_o$) and modulated in frequency with a sinusoidal modulating signal X(t) with amplitude $\Delta\omega$ (equal to the maximum frequency deviation of the modulated signal) and pulsation $\omega_m$, i.e., with $X(t)=\Delta\omega \cdot cos(\omega_m \cdot t)$ (see Eq. (3)), it is possible to show that, in phase-locked and steady-state conditions, the control signal $V_o(t)$ downstream of the unitary filter 3a is given by

$$V_o(t) = \frac{\omega_o - \omega_{VCO}}{K_{VCO}} + \frac{\Delta\omega}{\left| j\omega + K_{VCO}e^{-j\omega\tau_G} \right|} sen\left[ \omega_m t - \angle H(\omega_m) \right], \quad with \quad \omega = \omega_m \qquad (5)$$

where $H(\omega)$ is the transfer function of the digital phase-locked loop 10 with respect to the modulating signal X(t). In greater detail, given the corresponding Laplace transforms $V_o(s)$ and X(s), respectively, of the output signal $V_o(t)$ and of the modulating signal X(t), the transfer function $H(\omega)$ with respect to the modulating signal X(t) is given by

$$H(\omega) = \frac{V_O(s)}{X(s)} = \frac{e^{-j\omega\tau_G}}{j\omega + K_{VCO}e^{-j\omega\tau_G}} \qquad (6)$$

As highlighted by Eq. (5), the output signal $V_o(t)$ corresponds to the modulating signal X(t) but for variations of amplitude and of phase that depend upon the transfer function $H(\omega)$.

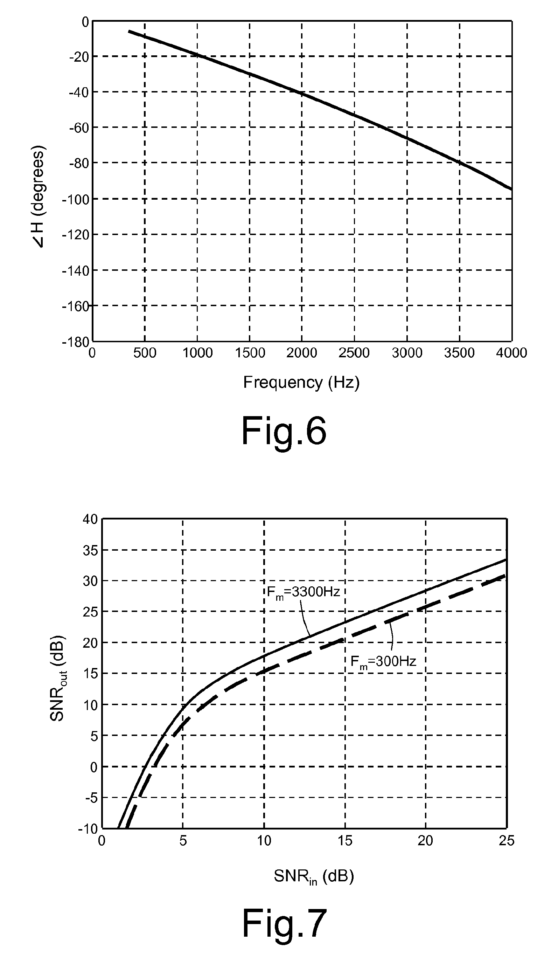

By way of example, given in Figures 5 and 6 are, respectively, the plot of the magnitude and the plot of the phase of the transfer function $H(\omega)$ in the case of FIR filters 22a and 22b with seven coefficients, coefficient of proportionality $K_{VCO}$ equal to 18000, and sampling frequency F$_c$ of 100 kHz.

As emerges from Figures 5 and 6, the transfer function $H(\omega)$ is such that, in the presence of a non-sinusoidal input signal $s_i(t)$, it undergoes a contained linear distortion such that the digital phase-locked loop 10 described is particularly effective when used as demodulator of frequency-modulated signals.

The performance of the digital phase-locked loop 10 can be appreciated also from an analysis of the plot of the signal-to-noise ratio SNR$_{OUT}$ of the output signal $V_o(t)$ with respect to the signal-to-noise ratio SNR$_{IN}$ of the input signal $s_i(t)$, and in particular from an analysis of the signal-to-noise ratio SNR$_{OUT}$ where there occurs the threshold phenomenon, characteristic of phase-locked loops. As is known, said threshold phenomenon consists in the presence of a value of signal-to-noise ratio SNR$_{OUT}$ equal to the signal-to-noise ratio SNR$_{IN}$ of the input signal $s_i(t)$ less 1 dB, a value beyond which the values of the signal-to-noise ratio SNR$_{OUT}$ of the output signal $V_o(t)$ become greater than the corresponding values of the signal-to-noise ratio SNR$_{IN}$ of the input signal $s_i(t)$.

In this connection, given in Figure 7 are the plots of the signal-to-noise ratio SNR$_{OUT}$ of the output signal $V_o(t)$

corresponding to two different frequencies of the modulating signal, 3300 Hz (solid line) and 300 Hz (dashed line); in both cases the maximum frequency deviation of the modulated signal is equal to 6500 Hz, whilst the coefficient of proportionality $K_{VCO}$ is equal to 31242. The instantaneous band of the modulated signal is equal to 20 kHz, whilst the output audio band is limited to 4 kHz by an output FIR filter.

It can be shown that the relation between the values of the signal-to-noise ratio $SNR_{OUT}$ of the output signal and the values of the signal-to-noise ratio $SNR_{IN}$ of the input signal can be optimized with respect to the value of the coefficient of proportionality $K_{VCO}$. In Figure 7 the value $K_{VCO}$ = 31242 has been used, which is precisely the value that renders the signal-to-noise ratio $SNR_{OUT}$ maximum.

From Figure 7, it may be noted how the present digital phase-locked loop 10 has threshold values at values of the signal-to-noise ratio $SNR_{OUT}$ of the output signal $V_o(t)$ of approximately 4 dB, i.e., threshold values at least 2 dB lower than the threshold values characteristic of the main demodulators for frequency-modulated signals available on the market, such as for example frequency discriminators.

As regards, instead, the stability of the digital phase-locked loop 10 described, the presence of a unitary filter 3a guarantees the stability of the digital phase-locked loop 10 with a sufficient stability margin, which can be calculated, once the sampling frequency $F_c$ of the input signal $s_i(t)$ is known, by means of the equation $K_{VCO} < (\pi/N)^* F_C$, obtained by applying the known stability criteria for feedback systems, as described in greater detail in what follows.

The digital phase-locked loop 10 can be implemented, by using a corresponding software module, either by a microprocessor, such as for example a DSP (Digital Signal Processor), or by an FPGA (Field Programmable Gate Array).

In the framework of these software implementations, an advantageous embodiment of the digital phase-locked loop 10 envisages that both the sine and cosine functions of the QVCO 40 and the arctangent function of the calculation block 23 are calculated by means of approximations linked to polynomial developments (developments in Taylor series) of the respective arguments.

In greater detail, and with reference to the calculation block 23, if z is the argument of the arctangent function, i.e., the ratio between the amplitude of the quadrature component $s_{iq}(t)$ and the amplitude of the in-phase component $s_{ii}(t)$, the calculation of the arctangent function y of the argument z is articulated in different steps implemented by the calculation block 23.

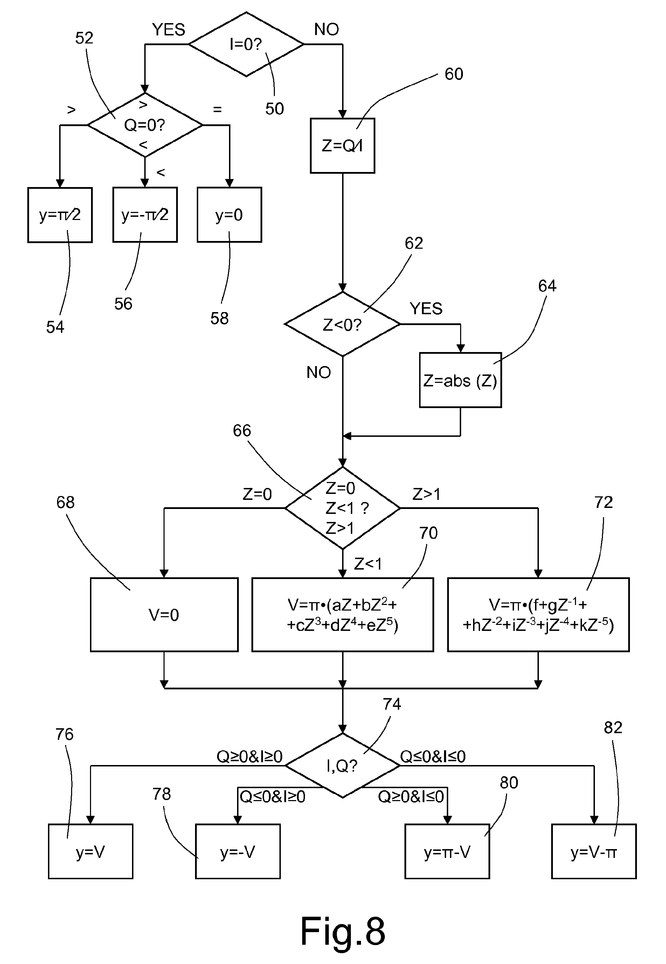

As illustrated in Figure 8, in the case where the amplitude I of the in-phase component $s_{ii}(t)$ is zero (output YES from step 50), the calculation block 23 verifies the sign of the quadrature component $s_{iq}(t)$ (step 52): if the amplitude Q of the quadrature component $s_{iq}(t)$ is positive, the calculation block 23 sets $y$ equal to $\pi/2$ (step 54); if it is negative, the calculation block 23 sets $y$ equal to $-\pi/2$ (step 56); if it is zero, the calculation block 23 sets y equal to 0 (step 58).

If the amplitude I of the in-phase component $s_{ii}(t)$ of the input signal $s_i(t)$ is nonzero (output NO from step 50), the calculation block 23 computes the argument $z$, equal to the ratio between the amplitude Q of the quadrature component $s_{iq}(t)$ and the amplitude I of the in-phase component $s_{ii}(t)$ (step 60), and verifies the sign thereof (step 62). In the case where the argument $z$ is negative (output YES from step 62), the calculation block 23 sets the argument $z$ equal to its absolute value $abs(z)$ (step 64) since for the subsequent steps only the modulus of the argument $z$ is relevant.

Next, the calculation block 23 calculates a support variable V, after prior verification of the modulus of the argument $z$ (step 66). In particular, the support variable V is calculated in the following way:

- in the case where the argument $z$ is zero, V is set equal to 0 (step 68);
- in the case where the argument z is less than 1, V is set equal to $\pi \cdot [a \cdot z + b \cdot z^2 + c \cdot z^3 + d \cdot z^4 + e \cdot z^5]$, where a = 0.318253, b = 0.003314, c = -0.130908, d = 0.068542, and e = -0.009159 (step 70);
- otherwise, V is set equal to $\pi \cdot [f + g \cdot z^{-1} + h \cdot z^{-2} + i \cdot z^{-3} + j \cdot z^{-4} + k \cdot z^{-5}]$, where f = 0.5, g = -0.318253, h = -0.003314, i = 0.130908, j = -0.068542, k = +0.009159 (step 72).

Once the support variable V has been calculated in the first quadrant, the calculation block 23 determines to which quadrant the angle to be calculated belongs (block 74):

- in the case where the amplitude Q of the quadrature component $s_{iq}(t)$ and the amplitude I of the in-phase component $s_{ii}(t)$ are both non-negative, the angle to be calculated belongs to the first quadrant; hence the arctangent $y$ is set equal to the support variable V (step 76);
- in the case where the amplitude Q of the quadrature component $s_{iq}(t)$ is non-positive and the amplitude I of the in-phase component $s_{ii}(t)$ is non-negative, the angle to be calculated belongs to the fourth quadrant; hence the arctangent $y$ is set equal to the support variable V, but with a negative sign (step 78);
- in the case where the amplitude Q of the quadrature component $s_{iq}(t)$ is non-negative and the amplitude I of the in-phase component $s_{ii}(t)$ is non-positive, the angle to be calculated belongs to the second quadrant; hence the arctangent $y$ is set equal to the difference between $\pi$ and the support variable V (step 80); and
- in the case where the amplitude Q of the quadrature component $s_{iq}(t)$ and the amplitude I of the in-phase component $s_{ii}(t)$ are both non-positive, the angle to be calculated belongs to the third quadrant; hence the arctangent $y$ is set equal to the difference between the support variable V and π (step 82).

The calculation described enables calculation of the arctangent function through 360° without resorting to the use of lookup tables, with the advantage of saving data memory and being able to calculate the arctangent function for exact values of the argument and not for values interpolated starting from values present in the lookup table.

The present digital phase-locked loop 10 is suited to multiple uses, and in particular can be advantageously integrated in a receiver of frequency-modulated signals in the VHF/UHF (Very High Frequency/Ultra High Frequency) band.

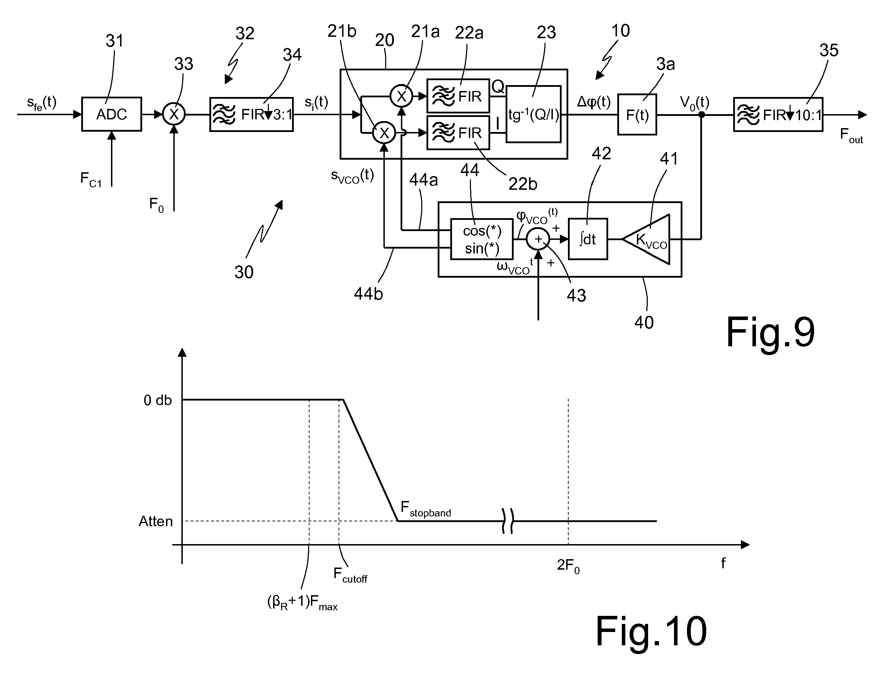

By way of example, Figure 9 shows a digital-processing system 30, i.e., the part of receiver that is typically set downstream of a corresponding analog receiving unit (receiving antenna, filters, etc.), not illustrated in Figure 9.

The digital-processing system 30 comprises:

- an analog-to-digital converter 31, designed to receive a signal $s_{fe}(t)$ processed by the analog receiving unit, typically pre-translated to an intermediate frequency $F_{IF}$, by the analog receiving unit itself, and to generate corresponding samples at a first sampling frequency $F_{c1}$;
- a selection block 32, comprising a multiplier 33, designed to multiply the samples of the signal $s_{fe}(t)$ processed by the analog receiving unit for a sinusoidal signal of translation having a translation frequency $F_{ol}$, and a first decimator FIR filter 34, set downstream of the multiplier 33; the selection block 32 is designed for selecting one from among the replicas of the signal $s_{fe}(t)$ processed by the analog receiving unit generated by the sampling made by the analog-to-digital converter 31, i.e., for generating the input signal $s_i(t)$;
- the digital phase-locked loop 10 described previously, set downstream of the selection block 32 and operating at the sampling frequency $F_c$, typically submultiple of the first sampling frequency $F_{c1}$ of the analog-to-digital converter 31 and defined by the ratio of decimation of the first decimator FIR filter 34;
- an output decimator FIR filter 35, set downstream of the digital phase-locked loop 10, designed to filter and decimate the samples at output from the digital phase-locked loop 10 so as to generate at output a flow of samples at an output frequency $F_{out}$ that is a submultiple of the sampling frequency $F_c$.

The digital-processing system 30 and the digital phase-locked loop 10 comprised therein can be designed in the way that is described hereinafter, which regards a non-limiting illustrative situation, in which the input signal $s_i(t)$ has a frequency $F_0$, hereinafter for reasons of convenience defined as "carrier frequency", and is frequency-modulated with a modulating signal X(t) having a modulating frequency $F_m$ comprised in the audio band 300-3300 Hz, i.e., having a maximum frequency $F_{max}$ of 3300 Hz; the maximum frequency deviation ΔF of the modulated signal is 6500 Hz. In addition, an intermediate frequency $F_{IF}$ of the analog receiving unit is assumed as being 437.5 kHz, and a translation frequency $F_{ol}$ of the harmonic translation signal is assumed as being 112.5 kHz.

Mathematically, the input signal $s_i(t)$ and the modulating signal X(t) can be written as

$$X(t) = \Delta F \cdot \cos(2\pi F_m \cdot t) \tag{7}$$

$$s_i(t) = A_i \cdot \cos[2\pi F_0 \cdot t + \phi_i(t) + \phi] = A_i \cdot \cos\left[2\pi F_0 \cdot t + \int X(t)dt + \phi\right] \tag{8}$$

where the carrier frequency $F_0$ is 25 kHz, given the aforementioned values of the intermediate frequency $F_{IF}$ of the receiving unit (437.5 kHz) and of the translation frequency $F_{ol}$ of the harmonic translation signal (112.5 kHz), in addition to the selection, not described in detail in so far as it is based upon known signal-processing techniques, of the replica of the signal $s_{fe}(t)$ processed by the analog receiving unit that is closest to the baseband.

On these assumptions, the instantaneous band $B_{IF}$ of the input signal $s_i(t)$ can be calculated using Carson's formula:

$$B_{IF} = 2(\beta + 1) \cdot F_m \tag{9}$$

where β is the modulation index, i.e., $\beta = \Delta F/F_m$.

Given the input signal $s_i(t)$ described, the signal $V_o(t)$ at output from the digital phase-locked loop 10 has a

residual modulation index $\beta_R$ equal to the amplitude of the error signal $\Delta\phi(t)$ produced by the phase detector 20. At the design level, the aforementioned value of residual modulation index $\beta_R$ must be lower than $\pi$, to guarantee hold of the phase locking. Furthermore, the residual modulation index $\beta_R$ determines the mask that must be implemented by the FIR filters 22a and 22b, an illustrative example of which is given in Figure 10. In fact, given the residual modulation index $\beta_R$, the FIR filters 22a and 22b must have a passband (cutoff frequency) equal to at least $(\beta_R+1)F_{max}$, with $\beta_R$ generally set at $\pi$, with the consequence that the carrier frequency $F_0$ of the input signal $s_i(t)$ must be higher than $(\beta_R+1)F_{max}$. Furthermore, the carrier frequency $F_0$ of the input signal $s_i(t)$ must be less than, or at the most equal to, one fourth of the sampling frequency $F_c$; i.e., it must be

$$F_0 \leq \frac{F_C}{4} \qquad (10)$$

so that the frequency $2F_0$, i.e., twice the carrier frequency $F_0$ of the input signal $s_i(t)$, is equal to or less than the Nyquist frequency, equal to $F_c/2$, i.e., half the sampling frequency.

In practice, given the carrier frequency $F_0$ of the input signal $s_i(t)$, the stop-band frequency of the FIR filters 22a and 22b can be set equal to $2F_0-(\beta_R+1)F_{max}$. Instead, the attenuation introduced by the FIR filters 22a and 22b can be chosen so that the number N of coefficients of the FIR filters 22a and 22b is minimum, at the same time observing the constraints imposed to satisfy the stability criteria, summarized in the following equation:

$$\frac{F_c}{2N} > F_{max} \qquad (11)$$

In particular, Eq. (11) expresses mathematically the constraint that the frequency at which the open-loop transfer function of the digital phase-locked loop 10 introduces a phase offset of 90 degrees is higher than the maximum frequency $F_{max}$ of the modulating signal X(t), i.e., that the frequency of oscillation of the loop falls outside the audio band.

Once the FIR filters 22a and 22b have been sized, it is possible to design the coefficient of proportionality $K_{veo}$ of the QVCO 40, which must satisfy the following equations:

$$K_{VCO} > \omega \cdot sen(\omega\tau_G) + \sqrt{\frac{\Delta\omega^2}{\pi^2} - \omega^2 \cdot \cos^2(\omega\tau_G)}, \quad \text{with } \omega = 2\pi F_{max} \qquad (12)$$

$$K_{VCO} < \frac{\pi}{N}F_c \qquad (13)$$

Eq. (12) derives from having imposed upon the residual modulation index $\beta_R$ the condition of being less than $\pi$ to guarantee hold of the phase locking.

Eq. (13) derives, instead, from application of the known stability criteria for feedback systems to the digital phase-locked loop 10 described. In fact, by applying to the open-loop transfer function $H_{loop} = \dfrac{K_{VCO}}{j\omega}e^{-j\omega\tau_G}$ the condition $|H_{loop}(\omega\tau_g = \pi/2)| < 1$, we arrive at Eq. (13).

In due respect of Eqs. (10) and (11), it is possible to maximize the coefficient of proportionality $K_{VCO}$ so as to guarantee at output from the phase detector 20 an error signal (phase difference) $\Delta\phi(t)$ of less than $\pi$. By so doing, the range of values admissible for the cutoff frequency of the FIR filters 22a and 22b widens, with consequent reduction in the number of coefficients of the FIR filters 22a and 22b themselves and, hence, of the group delay $\tau_G$ introduced by the FIR filters 22a and 22b, thus optimising the stability margin.

The digital phase-locked loop 10, advantageously designed as described previously, can be effectively used in the demodulation of input signals $s_i(t)$ that are frequency-modulated and affected by the Doppler effect, for example because they are emitted by a source moving at a speed v. In fact, the present digital phase-locked loop 10 proves to be only slightly influenced by the Doppler effect, which causes a frequency shift of the spectrum of the input signal $s_i(t)$ equal to the ratio between the speed v of the source and the wavelength X of the input signal $s_i(t)$, obtained as ratio between the speed of light in a vacuum and the carrier frequency $F_0$. This frequency shift causes a difference in frequency between the carrier frequency $F_0$ of the input signal $s_i(t)$ and the rest frequency $F_{vco}$ of the QVCO 40 ($F_{vco} = \omega_{VCO}/2\pi$), said difference in frequency causing an offset on the output signal $V_o(t)$ (see Eq. (5)); this offset is, however, of modest degree in so far as it is equal to the aforementioned difference divided by the coefficient of proportionality $K_{vco}$ of the QVCO 40. By way of example, it can be shown that, by applying Eq. (5) with v = 300m/s, $F_0$ = 400 MHz (UHF) and $K_{VCO}$ = 18000, we have:

$$\frac{\left(\omega_0 - \omega_{VCO}\right)}{K_{VCO}} \cong 0,14 \tag{14}$$

It is evident that modifications and variations may be made to the digital phase-locked loop 10 described herein, without thereby departing from the scope of the present invention, defined by the annexed claims.

Furthermore, practical (numerical) implementation of some of the constitutive blocks (phase detector, loop filter, voltage-controlled oscillator) can vary with respect to what has been illustrated herein, provided that they operate according to what is defined in the annexed claims. Likewise, the calculation of the arctangent function can be made using algorithms different from the one proposed, for example by recourse to a lookup table. It is moreover possible to use a non-unitary loop filter, in which case it is advisable to use a quadrature voltage-controlled oscillator (QVCO) having high coefficient of proportionality Kvco, with possible reduction in the stability margin.

Finally, it is evident that the field of application of the present digital phase-locked loop is not limited to the field of demodulation of frequency-modulated input signals, but rather can be extended to other applications, such as, for example, reconstruction of subcarriers in the presence of digitally modulated signals.

**Claims**

1.   A digital phase-locked loop (10) configured to receive an input signal ($s_i(t)$), comprising oscillator means (40) and phase-detector means (20), wherein said oscillator means (40) are configured so as to generate a first harmonic signal and a second harmonic signal having the same reference phase ($\phi_{VCO}(t)$), but for a phase offset of 90 degrees, and said phase-detector means (20) are configured so as to calculate a quantity indicative of the difference between the phase ($\phi_i(t)$) of said input signal ($s_i(t)$) and said reference phase ($\phi_{VCO}(t)$) by means of extraction of an in-phase component ($s_{ii}(t)$) and of a quadrature component ($s_{iq}(t)$) of said input signal ($s_i(t)$).

2.   The digital phase-locked loop (10) according to Claim 1, wherein said phase detector (20) comprises calculation means (23) configured for calculating said phase difference between the phase ($\phi_i(t)$) of said input signal ($s_i(t)$) and said reference phase ($\phi_{VCO}(t)$) by calculation of a function of arctangent of the ratio between said quadrature component ($s_{iq}(t)$) and said in-phase component ($s_{ii}(t)$).

3.   The digital phase-locked loop (10) according to Claim 2, further comprising:

    - first and second multiplier means (21a, 21b) configured for multiplying said input signal ($s_i(t)$) by said first harmonic signal and, respectively, said second harmonic signal;
    - first and second filtering means (22a, 22b) set downstream of respective multiplier means (21a, 21b) so as to generate, respectively, said in-phase component ($s_{ii}(t)$) and said quadrature component ($s_{iq}(t)$) of said input signal $s_i(t)$.

4.   The digital phase-locked loop (10) according to Claim 3, wherein said first and second filtering means (22a, 22b) each comprise a respective FIR filter.

5.   The phase-locked loop (10) according to any one of Claims 2-4, wherein said calculation means (23) comprise means of polynomial approximation for calculation of said arctangent function.

6.   The digital phase-locked loop (10), according to any one of Claims 1-5, further comprising a unitary loop filter (3a) connected downstream of said phase-detector means (20).

7. The digital phase-locked loop (10) according to any one of Claims 1-6, wherein said oscillator means (40) comprise a quadrature voltage-controlled oscillator (QVCO).

8. The digital phase-locked loop (10) according to Claim 7, wherein said quadrature voltage-controlled oscillator (QVCO) comprises means of polynomial approximation for calculation of said first and second harmonic signals.

9. A digital-processing system (30), comprising:

   - an analog-to-digital converter (31) configured to receive a signal ($s_{fe}(t)$) at an intermediate frequency ($F_{IF}$) and to generate a plurality of samples having a first sampling frequency ($F_{c1}$) and a plurality of signal replicas ($s_{fe}(t)$);
   - selection means (32) comprising a multiplier (33) configured to multiply said samples of the signal ($s_{fe}(t)$) by a harmonic translation signal having a translation frequency ($F_{ol}$), and a decimator FIR filter (34) connected downstream of said multiplier (33), said selection means (32) selecting one from among said signal replicas ($s_{fe}(t)$) and generating a sampled signal ($s_i(t)$) having a sampling frequency ($F_c$); and
   - a digital phase-locked loop (10) according to any one of the preceding claims, receiving said sampled signal constituting said input signal ($s_i(t)$).

10. The digital-processing system (30) according to Claim 9, further comprising an output decimator FIR filter (35) set downstream of said digital phase-locked loop (10).

11. A computer-program product that can be loaded into a memory of a processor of a signal receiver and configured to implement, when run, the digital phase-locked loop (10) according to any one of Claims 1 to 8.

12. A method for phase locking of an input signal ($s_i(t)$), comprising the steps of:

   - receiving an input signal having a phase ($\phi_i(t)$);
   - generating a first harmonic signal and a second harmonic signal having the same reference phase ($\phi_{VCO}(t)$), but for a phase offset of 90 degrees;
   - extracting an in-phase component ($s_{ii}(t)$) and a quadrature component ($s_{iq}(t)$) of said input signal ($s_i(t)$); and
   - calculating a quantity indicating the difference between the phase ($\phi_i(t)$) of said input signal ($s_i(t)$) and said reference phase ($\phi_{VCO}(t)$) by means of said in-phase component ($s_{ii}(t)$) and quadratuRe component ($s_{iq}(t)$) of said input signal ($s_i(t)$).

13. The phase-locking method according to Claim 12, wherein said quantity is directly and linearly proportional to the difference between the phase ($\phi_i(t)$) of said input signal ($s_i(t)$) and said reference phase ($\phi_{VCO}(t)$).

14. The phase-locking method according to Claim 13, wherein the step of calculating said quantity comprises calculating the ratio between said quadrature component ($s_{iq}(t)$) and said in-phase component ($s_{ii}(t)$) of said input signal ($s_i(t)$) and calculating the function of arctangent of said ratio.

Fig.1

Fig.2

Fig.3

## Fig.4

## Fig.5

Fig.6

Fig.7

Fig.8

Fig.9

Fig.10

Europäisches
Patentamt

European
Patent Office

Office européen
des brevets

## EUROPEAN SEARCH REPORT

Application Number

EP 09 16 0318

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | US 5 742 207 A (RAMBO JEFFERY C [US] ET AL) 21 April 1998 (1998-04-21)<br>* the whole document *<br>----- | 1-8, 11-14<br>9,10 | INV.<br>H03L7/087 |
| X | US 2003/219082 A1 (TANAKA KATSUYUKI [JP] ET AL) 27 November 2003 (2003-11-27)<br>* paragraph [0065] - paragraph [0092] *<br>* paragraph [0102] - paragraph [0104] *<br>* paragraph [0150] - paragraph [0161] *<br>----- | 1-14 | |
| X<br>Y | WO 02/091578 A (KARIMI GHARTEMANI MASOUD [CA]) 14 November 2002 (2002-11-14)<br>* page 9, line 25 - page 10, line 17 *<br>----- | 1-7, 12-14<br>9,10 | |

TECHNICAL FIELDS
SEARCHED (IPC)

H03L

The present search report has been drawn up for all claims

| Place of search | Date of completion of the search | Examiner |
|---|---|---|
| Munich | 27 August 2009 | Kahn, Klaus-Dieter |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 09 16 0318

This annex lists the patent family members relating to the patent documents cited in the above-mentioned European search report.
The members are as contained in the European Patent Office EDP file on
The European Patent Office is in no way liable for these particulars which are merely given for the purpose of information.

27-08-2009

| Patent document cited in search report | | Publication date | Patent family member(s) | | Publication date |
|---|---|---|---|---|---|
| US 5742207 | A | 21-04-1998 | NONE | | |
| US 2003219082 | A1 | 27-11-2003 | JP | 4120237 B2 | 16-07-2008 |
| | | | JP | 2003258669 A | 12-09-2003 |
| | | | US | 2007160169 A1 | 12-07-2007 |
| WO 02091578 | A | 14-11-2002 | CA | 2346136 A1 | 09-11-2002 |

EPO FORM P0459

For more details about this annex : see Official Journal of the European Patent Office, No. 12/82